# EUROPEAN PATENT SPECIFICATION

(11) **EP 0 751 866 B1**
(45) Date of publication and mention of the grant of the patent: **21.04.1999**
(21) Application number: 95907614.2
(22) Date of filing: 25.01.1995
(51) Int. Cl.: B29C 70/22, B29C 70/50, B29C 70/68, B32B 31/00, B32B 15/08, H05K 1/03

(54) **METHOD OF MAKING A UD CROSSPLY PWB LAMINATE HAVING ONE OR MORE INNER LAYERS OF METAL**
VERFAHREN ZUR HERSTELLUNG EINER MEHRSCHICHTIGEN LEITERPLATTE AUS SCHICHTEN VERSTÄRKT MIT LÄNGSGERICHTETEN FASERN, SCHICHTEN VERSTÄRKT MIT QUERGERICHTETEN FASERN UND MINDESTENS EINER METALLENEN MITTELSCHICHT
PROCEDE DE FABRICATION D'UN STRATIFIE EN DIAGONALE, UNIDIRECTIONNEL POUR CARTES DE CABLAGE IMPRIME COMPORTANT UNE OU PLUSIEURS COUCHES INTERNES DE METAL

(30) Priority: 26.01.1994 EP 94200191
(43) Date of publication of application: 08.01.1997
(73) Proprietor: AMP-Akzo LinLam VOF, NL-6824 BM Arnhem (NL)
(72) Inventor: MIDDELMAN, Erik, NL-6815 CC Arnhem (NL); SERAPHIM, Donald, Philip, US-Vestal, NY 13850 (US)
(74) Representative: Schalkwijk, Pieter Cornelis, c.s.
(86) International application number: EP9500274
(87) International publication number: WO9520479

(56) References cited:
- EP-A- 0 157 261
- EP-A- 0 158 027
- EP-A- 0 347 936
- EP-A- 0 374 319
- EP-A- 0 447 642
- EP-A- 0 478 051
- WO-A-92/22192
- WO-A-94/02306
- CH-A- 675 852
- FR-A- 1 091 813
- FR-A- 2 649 643
- US-A- 3 939 024
- US-A- 4 402 778
- US-A- 4 659 425
- US-A- 5 024 714
- PATENT ABSTRACTS OF JAPAN vol. 14 no. 65 (E-884) ,6 February 1990 & JP,A,01 283996 (MITSUBISHI ELECTRIC CORPORATION) cited in the application
- PATENT ABSTRACTS OF JAPAN vol. 12 no. 343 (M-741) ,14 September 1988 & JP,A,63 104806 (SHIN KOBE ELECTRIC MACH CO) 10 May 1988,

## Description

The invention pertains to a method of manufacturing a composite laminate having a plurality of UD layers, i.e., layers of matrix material reinforced with unidirectionally oriented fibres, and at least one inner metal layer, i.e., a metal layer that does not form an outer surface of the laminate, the layers being arranged so as to give a balanced and symmetric laminate, the method comprising passing through a laminating zone unidirectionally oriented (UD) fibres provided with not yet consolidated matrix material and consolidating the matrix material. The invention particularly aims at making printed wire boards (PWBs) having an inner metal layer. Such PWBs are known. The inner metal layer, usually a copper layer, serves as a power or ground plane, or as a heat-sink, and may have a pattern of holes in it.

A method of manufacturing a composite laminate, wherein unidirectionally oriented (UD) fibres are provided with not yet consolidated matrix material and passed through a laminating zone, is known from EP 478 051. This document discloses the continuous manufacture of a flat substrate from a fibre-reinforced matrix, which process comprises the use of at least two moving layers of parallel, rectilinearly extending reinforcing fibres not bonded in the form of a woven fabric (UD fibres), providing said UD fibres, which are positioned in at least two crossing directions, with matrix material, and passing them through a laminating zone, for instance a double belt press, to form a cross-ply laminate. By this process laminates may be obtained which are pre-eminently suitable as PWB substrate on account of, int. al., their good surface area quality, their comparatively low linear thermal coefficient of expansion (TCE) in the x and y directions, the option of incorporating a high content of fibres, and their favourable dimensional stability. The possibility for the laminate to contain an inner metal layer is briefly referred to, without a method to incorporate such an inner metal layer being disclosed.

The type of PWB laminate described in EP 478 051 is known as a UD crossply PWB laminate. Such laminates comprise matrix material reinforced with unidirectionally oriented filaments such that the UD reinforcing filaments are present in different layers of crossing orientational directions, said layers being symmetrically positioned vis-à-vis a plane of symmetry through the centre of the laminate which runs parallel to its outer surfaces. Methods of making these UD crossply laminates have been described also in various other publications.

Thus, another method of manufacturing a UD layer-reinforced composite laminate, which likewise is intended to be used as a PWB substrate, is known from US 4,943,334. In this process reinforcing filaments are wound about a square flat mandrel in several layers crossing at an angle of 90°, with the filaments being provided with curable matrix material by means of injection and/or impregnation. The matrix, which in consequence contains cross-wise applied UD fibre layers, is then cured.

Composite materials for PWBs in which individual crosswise positioned UD layers are employed are known from US 4,814,945. This publication relates to a resin reinforced with parallel fibres of aramid being used as a PWB substrate. Several resin layers heated to a semi-cured or B stage and so UD-reinforced are placed one on top of the other and then cured.

In WO 92/22191 a method of manufacturing a PWB laminate is described involving the steps of making non-flowable UD layers, coating at least part of the non-flowable UD layers with an adhesive on one or both sides, crosswise stacking the UD-layers in such a way that there is at least one layer of adhesive between each pair of UD-layers having a different direction of orientation, and bonding the stacked UD-laminates by activating the adhesive layers.

Non-prepublished patent application PCT/EP93/01919 (publication number WO 94/02306) relates to a method of manufacturing a composite laminate, preferably a cross-ply laminate, in which process unidirectionally oriented (UD) fibres are provided with matrix material and, together with a pre-formed non-flowing UD composite or cross-ply laminate, passed through a laminating zone in layers of at least two different orientational directions. The co-lamination with metal foil is referred to as a possibility of using the laminate as a PWB substrate, i.e., to render the outer surface of the formed laminate conductive.

EP 157 261 discloses a printed circuit board laminating apparatus into which baseboards and a length of film are continuously fed, so as to laminate the film onto the surface of the baseboard.

EP 158 027 discloses a method of making a copper clad base material for printed wire boards. A layer of resin reinforced with a woven glass fabric is laminated with copper foil in a double belt press.

EP 52 738 discloses a PWB laminate, particularly a multi layer PWB having at least one inner conductive layer which is employed as a power plane. The laminate is made by stacking and pressing conventional insulating layers, such as prepregs, with a copper plate having a thickness of from 0.2 to 0.5 mm.

EP 264 105 discloses a method of producing a multi layer PWB containing a metal plate as an inner layer. The teaching of this patent publication is directed to the use of a metal plate having a peripheral portion that extends beyond the eventual size of the PWB. The PWB is made by stacking copper cores and prepreg layers.

EP 324 352 also discloses a method of making a PWB having an inner layer of metal which serves as a heat conductor. The PWB is produced using a thermal moulding technique.

Multi layer printed circuit boards comprising UD layers and layers of conductive circuitry have been disclosed in JP 01/283996, EP 374 319, and WO 92/22192.

The background art further includes methods of making laminates comprising layers of reinforced plastics and layers of metal.

Thus EP 447 642 discloses the formation of a "sandwich structure" consisting either of a metal layer enclosed between two layers of a reinforced thermoplastic material, or of a reinforced thermoplastic layer enclosed between two metal layers. The reinforcements are woven fabrics and the like, UD layers have not been disclosed. The method involves combining the various layers and pressing them at a temperature above the melting point of the thermoplastic resin.

US 4,402,778 discloses a method of making laminated structures comprising reinforced plastic sheets. The method involves inserting a panel, which may be a metallic sheet, into a double belt press together with two fibre reinforced plastic sheets enclosing the panel. The sheets may include any form of reinforcing material.

US 5,024,714 discloses a method of forming a composite structural member, the method comprising continuously feeding metal sheets and continuously extruding plastic sheets, and alternatingly laminating these metal and plastics sheets. The plastics sheets may comprise a reinforcement, which may be in the form of parallel filaments.

EP 347 936 discloses the continuous production of a laminated sheet, in which process several resin impregnated fibrous bases are laminated in a double belt press, optionally with a metal foil that constitutes the outermost layer of the laminated sheet.

A laminate comprising UD layers has been disclosed in FR 1,691,813. The UD layers are supported by a foil, which may be, e.g., paper, plastic or metal.

None of the above-mentioned prior art references teaches a method of making PWBs having at least one inner metal layer on the basis of laminates comprising UD reinforcement.

The invention aims at providing such a method. Particularly, the invention seeks to provide a method that allows the orientation of the fibres (filaments) in the UD layers to be retained. The method should allow the production of balanced and symmetric laminates in a simple manner and should be sufficiently versatile to allow different configurations of UD layers and metal layers. Further, the aim is to provide a method which will permit (semi)continuous production.

To this end, the method of the invention is characterized in that in a first step a non-flowing sandwich laminate of at least three layers is formed, the at least three layers being UD and metal layers, the sandwich laminate being formed by passing UD fibres provided with not yet consolidated matrix material through the laminating zone together with metal foil, and in a second step the non-flowing sandwich laminate is provided on its outer surfaces with UD layers, with additional UD layers optionally being added in subsequent steps. This "add-on" UD method is explained in more detail below.

In order to facilitate this explanation, the following abbreviations are used:
- M: metal;
- FR: UD fibres provided with not yet consolidated resin;
- UD: non-flowing UD layer;
- x: production direction (say: "0°" orientation);
- y: orthogonal to production direction (say: "90°" orientation);
The term "side" when used in connection with the laminating zone does not refer to the inlet and outlet sides of the zone, but to the sides of the resulting laminates. E.g., with a horizontally placed platen press, the two "sides" are the bottom and top platens. If the laminating zone is a double belt press, the two "sides" refer to the two belts.

The method of the invention satisfies the requirement that the orientation of all UD layers can be retained: the UD fibres provided with not yet consolidated matrix resin are tensioned as a result of their being passed through the laminating zone, and the orientation is fixated as a result of the matrix resin being rendered no longer flowable. In order to maximally profit from this advantage of the process of the invention, it is preferred to carry through the lamination in a double belt press, and to unwind the UD fibres from a creel in the form of endless filaments. As compared with the prior art, the process according to the invention thus provides easier and superior conservation of the orientation which is so vital to the manufacture of UD fibre reinforced composites.

in the first step a UD-metal-UD laminate can be made as follows: UD fibres-containing, not yet consolidated matrix material is provided symmetrically vis-à-vis the outer surfaces of a metal foil. The resulting stack of layers (FRx-M-FRx) is passed through the laminating zone, and the matrix resin is consolidated so as to form a UDx-M-UDx sandwich laminate in a non-flowing state. At a subsequent stage UD layers are added, i.e., the UD-M-UD sandwich laminate is passed through the laminating zone while FR layers are added on either side of the sandwich laminate. In order to obtain the desired balance (the same amount of resin and fibres in the 0° and the 90° direction) and symmetry (vis-à-vis a plane of symmetry through the centre of the laminate which runs parallel to its outer surfaces), a measured portion of the sandwich laminate (formed as a UDx-M-UDx laminate) can be formed (e.g., by cutting up at a length that is equal to the width) and introduced into the laminating zone turned 90 degrees, i.e., as a UDy-M-UDy sandwich laminate. For, with a view to practicability it is preferred for the orientational direction of the fibres which are provided with matrix material to be equal to the machine direction during the laminating process. Thus, a stack comprising FRx-UDy-M-UDy-FRx is passed through the laminating zone, so as to form a UDx-UDy-M-UDy-UDx laminate. If a thicker laminate is made, i.e., if several UD layers are added at subsequent stages, it does not matter at which stage the orientational direction is changed, as long as the required balance and symmetry are reached.

As an alternative, the first step may lead to the formation of a metal-UD-metal sandwich laminate. One possibility is that a metal foil is carried along with an FR layer and added on one side, and a bare metal foil is added on the other side. However, since the process of the invention is preferably carried out in symmetrical fashion (the same material being added simultaneously from both sides at each stage), it is preferred for the stack of layers passed through the laminating zone to be of the type M-FRx-FRx-M. After consolidation to a non-flowing stage, this will lead to M-UDx-UDx-M sandwich laminate (i.e., an M-UD-M sandwich in which the middle UD layer is of double thickness). In order to form a balanced and symmetric laminate, the M-UDx-UDx-M laminate can be cut into square pieces, which - turned 90 degrees, i.e., as an M-UDy-UDy-M sandwich laminate - can be passed through the laminating zone again, together with FR layers. This FRx-M-UDy-UDy-M-FRx stack will lead to the formation of a balanced and symmetric laminate having two inner metal layers: UDx-M-UDy-UDy-M-UDx.

The term "non-flowing" is used to indicate that the matrix material has been solidified (consolidated) to the extent of not being brought to flow again during the remainder of the manufacturing process. In general, this means that during storage and processing the non-flowing material is under such conditions of pressure and temperature that the matrix resin is in a state below its softening point (i.e., below Tg or apparent Tg). The several matrix material (matrix resin) stages are customarily identified in the art as the "A", "B", and "C" stages, the A stage indicating unsolidified resin (i.e., in the case of a thermoset resin: the uncured stage), the B stage generally indicating partial solidification (in the case of a thermoset resin: the reaction has proceeded through the formation of longer chains, but not to full network formation), and the C stage indicating a solidified (cured) stage. For convenience of storage and processing, it is preferred for the solidification of the non-flowing material that the resin has reached the C stage, or for resins to be used such as those comprising rigid molecular chains in which under regular storage and processing conditions a non-flowing state may already be attained at a stage still called the B stage. However, notably when in the laminating zone pressing is conducted under isobaric conditions, also A stage material can be employed. The terms A stage, B stage and C stage are known to the person of ordinary skill in the art and require no further elucidation here.

The term not yet consolidated matrix material refers to matrix material of sufficiently low viscosity under the conditions at which it is applied to the UD fibres as to allow impregnation, such as thermoplastic resins in the liquid state. Not yet consolidated thermoset resins generally are in the A or the B stage (except for those thermoset resins referred to above, for which it holds that they are no longer flowable in the B stage).

It should be noted that the passing through the laminating zone of UD fibres provided with not yet consolidated matrix material allows the use of a non-flowing material to which no stringent requirements with regard to adhesion apply, sufficient adhesion being provided by the as yet unconsolidated matrix material. The unconsolidated matrix material generally is a liquid, but could conceivably be a free flowing powder capable of being applied to the UD fibres.

In general, it is advisable to post-cure the composite laminate manufactured by a process according to the invention after the final laminating step, in order to ensure full conversion in all layers.

An additional advantage of the process according to the invention is that it is very suitable for the use of resins of a high molecular weight without the employment of a solvent, and also for catalysed resins (of importance in the case of electroless additive metallisation). Such commercially significant resins are insufficiently impregnated by methods in which various UD layers are stacked one on top of the other and subsequently impregnated (as described in EP 478 051 mentioned hereinbefore).

It is immaterial how the UD fibres provided with matrix material which are passed through the laminating zone together with the pre-formed, non-flowing material are provided. One possible method is to coat a fibre bed with matrix material, another consists of passing individual fibres through a bath containing matrix material. Alternatively, use may be made here of a UD prepreg. It is preferred that the fibres be passed through a feeding zone during or after which they are provided with matrix material. The feeding zone may involve means for spreading filaments and for adjusting tension and orientation. It is preferred that an unpressurized, preheated feeding zone be used. A viable heating means is direct gas flame heating.

Preference is given to the PWB laminate being so composed that the UD-reinforced layers are oriented as specified in one of the following models, with 0° and 90° standing for orthogonal orientational directions and the relative thickness of the layers being indicated by repeating the given orientation where necessary:
0°/90°Cu90°/0° (or UDx-UDy-M-UDy-UDx);
0°/90°90°/0°Cu0°/90°90°/0° (or UDx-Udy-UDy-UDx-M-UDx-UDy-UDy-UDx);
0°/Cu90°90°Cu/0° (or UDx-M-UDy-UDy-M-UDx);
0°/90°/0°/Cu90°90°Cu/0°/90°/0° (or UDx-UDy-UDx-M-UDy-UDy-M-UDx-UDy-UDx).
In general, for utilisation in PWBs the UD-reinforced layers in the laminate according to the invention will each have a thickness in the range of 6 to 800 µm, preferably of about 15 to 400 µm.

The inner metal layers may generally have a thickness in the range of from about 12 µm to 1 mm. For a heat-dissipating layer the higher thicknesses are preferred. A thickness of about 1 mm is preferred if the metal layer is aluminum foil, used to dissipate heat. If the layer is a copper layer, thicknesses of the order of 70 µm, 140 µm, 210 µm, are preferred for heat dissipation, and lower thicknesses, e.g. about 18 µm for ground or power planes. In the case of copper foil it is highly preferred that double treated copper foil is used, in order to obtain favourable adhesion with matrix resin on both sides without the use of adhesives or adhesion promotion agents being necessary.

Particularly advantageous results may be obtained when in the process according to the invention a double belt press is used as laminating zone in all the process steps described hereinbefore.

It should be noted that double belt presses are known to those of ordinary skill in the art, and no further elucidation in a general sense is required here. The method according to the invention may be practised using other types of laminating zones, but the use of a double belt laminating zone (not necessarily with pressure being exerted) is preferred.

Alternatively, the product made by the process according to the invention (UD-metal-UD sandwich laminate, UD-metal-UD-metal-UD sandwich laminate, or eventually resulting cross-ply laminate) may be subjected to a surface treatment to improve adhesion. Such treatments, e.g., the corona treatment and the low pressure plasma treatment, are known. They are best carried out downstream of the laminating zone and prior to any coating being applied.

It may be advantageous to pre-treat the belts in the laminating zone with a release agent. Release agents are known and are found primarily in two forms, i.e., those that transfer to the material guided through the laminating zone, and those that do not. The latter are preferred, though use may be made with advantage of the former if a surface treatment such as described above is to follow, since any transferred release agent may be removed during such a treatment. Alternatively, to prevent adhesion to the belts in the laminating zone a release foil may be carried along.

The materials employed in carrying through the present invention are not especially critical. Preferably, use is made of the materials discussed hereinafter.

The matrix material is a thermoplastic or a thermosetting polymer, preference being given to thermosetting resins. More preferred is the use of an epoxy resin based matrix material, but other resins are also useful in principle. Examples include cyanate esters, unsaturated polyester (UP) resins, vinyl ester resins, acrylate resins, BT epoxy resin, bismaleimide resin (BMI), polyimide (PI), phenol resins, triazines, polyurethanes, silicone resin, biscitraconic resin (BCI). Alternatively, combinations of said resins may be employed, and it is also possible to mix the aforementioned resins with certain appropriate thermoplasts, such as PPO, PES, PSU, and PEI among others. It is of advantage to incorporate compounds into the matrix material which will render it flame-resistant, such as phosphorus or halogen-(particularly bromine-) containing compounds. A particular matrix material which is preferred for its favourable flow and curing properties comprises about 100 parts by weight of Epikote®828 EL, about 73 parts by weight of Epikote®5050, and about 30 parts by weight of isophorone diamine.

With respect to the addition of flame-retardancy rendering compounds, notably bromine compounds, it is further noted that in view of their detrimental effect on the environment, such compounds should be used in minimal quantities. The process according to the invention is advantageous in this respect in that it allows for the various layers in the laminate to be put together in such a way that only the outer layers are substantially flame-resistant, which is sufficient to prevent the laminate from catching fire. Such a step may also be taken in the case of multilayer PWBs.

To the matrix material fillers may be added in the conventional manner, for instance quartz powder and glass powders such as boron-silicate glass powder. Furthermore, the matrix may be rendered catalytic for electroless copperplating, e.g. by adding noble metal or compounds of noble metal, notably palladium.

While the preferred reinforcing material consists of filament yarns (untwisted strands), non-continuous fibres may also be employed. According to the invention, the reinforcing yarns are preferably selected from the following group of materials: glass, e.g. E-glass, A-glass, C-glass, D-glass, AR-glass, R-glass, S1-glass, and S2-glass, as well as various ceramic materials, such as alumina and silicon carbide. Also suited to be used are polymer based fibres, more particularly so-called liquid-crystalline polymers, such as paraphenylene terephthalamide (PPDT), polybenzobisoxazole (PBO), polybenzobisthiazole (PBT), and polybenzoimidazole (PBI), as are fibres based on polyethylene naphthalate (PEN), polyethylene terephthalate (PETP), and polyphenylene sulphide (PPS).

In general, the fibre content in the matrix is about 10-90 vol.%, preferably in the range of about 40 to about 70 vol.%. A fibre volume fraction of about 50 vol.% is highly satisfactory.

The invention also relates to multi-layer PBWs (MLBs). In particular, the composite laminates according to the invention are very suited to be used in the process as specified in WO 92/22192 which is to be considered incorporated herein by reference. According to this process, a hard base substrate provided with traces on both sides is laminated with an intermediate substrate, such that the intermediate substrate is composed of a hard core layer with a still plastically deformable adhesive layer at least at the side facing the conductive traces of the base substrate, and such a pressure is exerted on the laminate as will bring said hard core layer of the intermediate substrate into contact, or virtually into contact, with the conductive traces of the base substrate and fill the void between these traces with the adhesive material which bonds the base substrate and the intermediate substrate together. The metal layer-containing crossply laminates according to the invention are highly suitable for use in the base substrate as well as the intermediate substrate. Thus, the invention also pertains to the use of a UD crossply laminate made by a method according to the foregoing description for manufacturing an adhesive-coated insulating panel.

Of course, the void-filling, flowable, adhesive layer can be applied on the present laminates whenever desired. However, the method described hereinbefore, by which an adhesive layer may advantageously be provided on a composite laminate, is pre-eminently suited to be used for the manufacture of the intermediate substrates provided with the void-filling adhesive. Preference is given to the base substrate provided with traces being a PWB which was also made by the process according to the invention. A large number of polymers is suitable for use as a trace-filling glue, more particularly thermosets, such as epoxy resin (EP), polyurethane (PU), vinyl ester (VE), polyimide (PI), bismaleimide (BMI), biscitraconimide (BCI), cyanate esters, triazines, acrylates, and mixtures thereof. A wide range of additives may be added to the glue prior to its application, for instance catalysts, inhibitors, surface-active agents, thixotropic agents, and especially fillers. Said fillers are preferably selected from the following group of materials: quartz powder, glass powder, ceramic powders such as alumina powder. Preferably, the fillers to be used should have a low thermal coefficient of expansion and a low dielectric constant. Favourable results can be attained by using hollow spheres as filler, which spheres may be of either a polymeric or a ceramic material or of glass. Expandable polymeric powders in particular are suitable for use as filler.

In addition, the composite laminates manufactured using the process according to the invention are pre-eminently suited to be used as supporting material in devices with various integrated circuits provided thereon (multichip modules). This is notably due to the favourable TCEs, which are mostly the result of the high fibre volume fraction that can be obtained when cross-ply laminates are used, and which may be about equal to the TCEs of electronic components (chips) used in conjunction with PWBs, more particularly MLBs. Such components may be provided on top of an MLB (chip-on-board) or else be provided embedded in a substrate such as an intermediate substrate according to WO 92/01133 (chip-in-board). Further, the process according to the invention, and the composite laminates manufactured using it, may be employed in so-called mass lamination (masslam). This process generally comprises a layer provided on both sides with electrically conductive traces being laminated with prepreg on the sides provided with the traces. According to the invention, use may be made with advantage, in continuous operation or not, of the masslam process, in which a layer provided with electrically conductive traces on both sides is passed through the laminating zone instead of - or in combination with - the pre-formed, non-flowing composite, and provided on either side with a layer of UD fibres-containing matrix material, especially when using a double belt press. In a subsequent laminating step, the PWB provided with UD layers thus manufactured may be laminated anew with UD layers, this time of opposite orientation, as essentially described hereinbefore.

The invention will be further illustrated with reference to the drawings. The drawings are presented for purposes of illustration only and should not be considered limitative in any way.

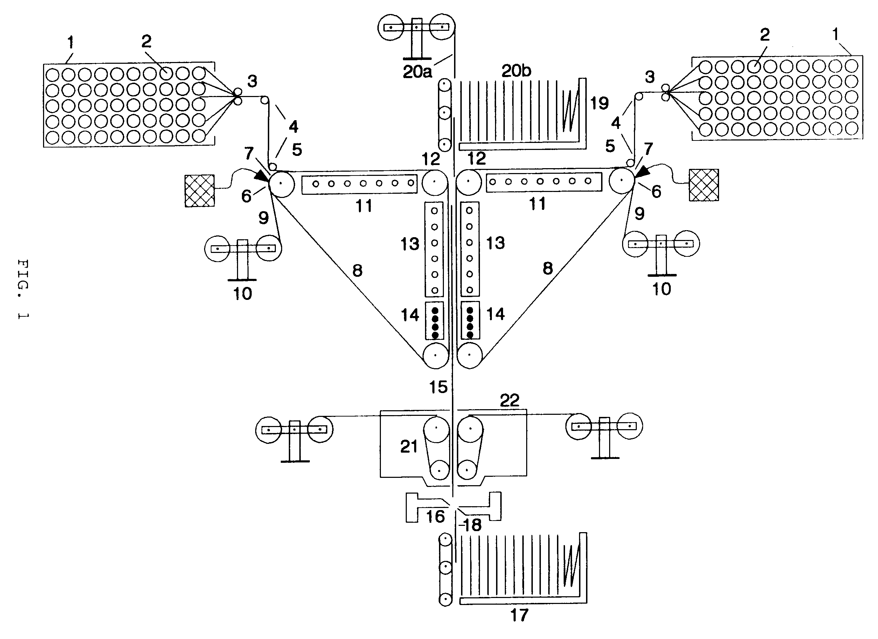

Figure 1 relates to a preferred embodiment of the invention, according to which a single double belt press is employed for both the manufacture of a UD-metal-UD sandwich laminate, and the resulting metal layer-containing, midplane symmetric, UD-crossply laminate.

The figure shows a cross-section parallel to the machine direction of a device with which the process according to the present invention may be carried out. A description of the process's depicted mode of use, together with the device's component parts, is given below.

### Forming the UD-metal -UD sandwich laminate:

Packages (2) unwind from two creels (1), preferably rolling, and so form a unidirectional bed of filament bundles (3), which is converted into a homogeneous unidirectional filament bed (5) with the aid of a yarn spreader (4).

By means of a coating unit (6) a matrix film (7) is provided on a continuous belt (8), or on a strip of foil (9) unwound from twin leaving stands (10), after which the matrix film (7) is brought together with the homogeneous unidirectional filament bed (5).

In the heated zone (11) there is impregnation and de-aeration. The two matrix-impregnated UD filament layers (12) are brought together with copper foil (20a), and then pass through the heated laminating zone (13). The copper foil (20a) is guided through the laminating zone (13), such that it is provided on either side with impregnated UD fibres (12). In the laminating zone (13) the two UD layers and the copper foil are fused together to form one UD-metal-UD sandwich laminate.

After this, the product passes through the cooling zone (14), which it leaves as a virtually continuous band (15). This band is cut up (16) and stored (e.g. in a box or on a pallet) (17).

### Forming the cross-ply laminate:

The same actions as described above are carried out, up to the introduction of the impregnated UD fibres into the laminating zone (13). Instead of copper foil (20a), from a box (19) panels of non-flowing UD-metal -UD sandwich laminate rotated 90° vis-à-vis the machine direction (20b) are guided through the laminating zone (13), such that the panels are provided on either side with impregnated UD fibres (12), the orientational direction of the UD fibres in the panels (18) thus being perpendicular to the orientation of the impregnated UD fibres (12). The pressed material is then treated as described hereinbefore to form the final cross-ply laminate (not depicted separately in the figure). This procedure may be repeated until the desired number of layers or the desired product thickness has been achieved.

Depending on the final application of the laminate, it may be provided with an adhesive layer with the aid of a double-sided coater (21), optionally in clean box (22). Such an adhesive layer may be the above-disclosed "additive adhesive" for electroless copperplating, but it may also be a glue such as indicated in WO 92/22192 for the manufacture of multi-layer PWBs. Alternatively, a photosensitive layer (photoresist) may be applied in this way.

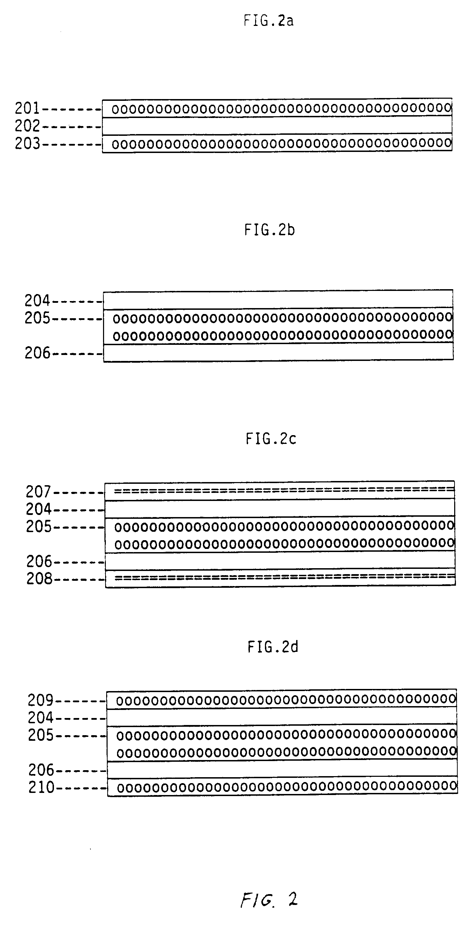

Figure 2 depicts, in cross-section, several basic materials that can be formed and used according to the present invention.
Thus, FIG. 2a shows a UD-metal-UD sandwich laminate comprising a 0° UD layer (201), a metal layer (202), and a 0° UD layer (203).
FIG. 2b shows a metal-UD-metal sandwich laminate comprising a metal layer (204), a 0° UD-layer (205) which as a result of the process employed has a double thickness, and a metal layer (206).
FIG. 2c shows a UD-metal-UD-metal-UD sandwich laminate made by adding UD layers to the laminate of FIG.2b, containing a 90° UD layer (207), a metal layer (204), a 0° UD layer (205), a metal layer (206), and again a 90° UD layer (208).
FIG. 2d shows an alternative to FIG. 2c, according to which also the outer UD layers (209 and 210) have 0° direction.

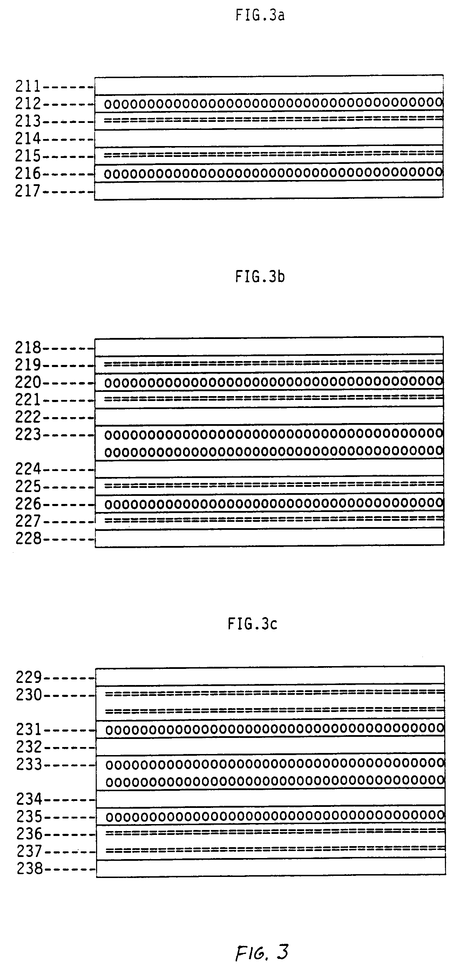

Figure 3 relates to the resulting crossply laminates.
FIG. 3a depicts a laminate having an outer metal layer (211), a 0° UD layer (212), a 90° UD layer (213), an inner metal layer (214), a 90° UD layer (215), a 0° UD layer (216), and an outer metal layer (217).
FIG. 3b depicts a laminate having an outer metal layer (218), a 90° UD layer (219), a 0° UD layer (220), a 90° UD layer (221), a metal layer (222), a 0° UD layer of double thickness (223), a metal layer (224), a 90° UD layer (225), a 0° UD layer (226), a 90° UD layer (227), and an outer metal layer (228).
FIG. 3c depicts a laminate having an outer metal layer (229), a 90° UD layer of double thickness (230), a 0° layer (231), a metal layer (232), a 0° UD-layer of double thickness (233), a metal layer (234), a 0° UD-layer (235), again a 90° layer of double thickness (236), and an outer metal layer (237).

## Claims

1. A method of manufacturing a composite laminate having a plurality of UD layers, i.e., layers of matrix material reinforced with unidirectionally oriented fibres, and at least one inner metal layer, i.e., a metal layer that does not form an outer surface of the laminate, the layers being arranged so as to give a balanced and symmetric laminate, the method comprising passing through a laminating zone unidirectionally oriented (UD) fibres (5) provided with not yet consolidated matrix material (7) and consolidating the matrix material, characterised in that in a first step a non-flowing sandwich laminate of at least three layers is formed, the at least three layers being UD (201, 203, 205) and metal layers (202, 204, 206), all fibres within the non-flowing sandwich laminate having a single direction of orientation, the sandwich laminate being formed by passing UD fibres provided with not yet consolidated matrix material through the laminating zone (13) together with metal foil (9), and in a second step the non-flowing sandwich laminate is provided on its outer surfaces with UD layers (207/208, 209/210), with additional UD layers optionally being added in subsequent steps.

2. A method according to claim 1, characterized in that the laminating process is carried out using a double belt press.

3. A method according to claim 2, characterized in that in the laminating zone, alongside of the two outer surfaces of the non-flowing sandwich laminate, there is introduced not yet consolidated matrix material provided with UD fibres having an orientational direction which is about perpendicular to the orientational direction in the sandwich laminate.

4. A method according to any one of claims 1 to 3, characterized in that a UD-metal-UD sandwich laminate is formed by inserting a metal foil in between two layers of UD fibres provided with not yet consolidated matrix material and passing the unconsolidated matrix material-containing metal foil thus UD reinforced on both its surfaces through the laminating zone.

5. A method according to claim 4, characterized in that in the laminating zone, alongside of the two outer surfaces of the non-flowing UD-metal-UD sandwich laminate (201, 202, 203), there is introduced not yet consolidated matrix material provided with UD fibres having an orientational direction which is about perpendicular to the orientational direction in the UD-metal-UD sandwich laminate.

6. A method in accordance with claim 5, characterized in that the measured portion of UD-metal-UD sandwich laminate is formed by cutting up endless UD-metal-UD sandwich laminate formed in the first step at a length that is about equal to the width.

7. A method according to any one claims 1 to 3, characterized in that in the first step a metal-UD-metal sandwich laminate is formed, the metal-UD-metal sandwich laminate comprising a UD layer (205) sandwiched by two conductive metal layers (204, 206), by passing two sheets or bands of metal foil through the laminating zone with the UD fibres provided with not yet consolidated matrix material in between them.

8. A method according to claim 7, characterized in that in the second step a UD-metal-UD-metal-UD laminate is formed, the UD-metal-UD-metal-UD laminate comprising the metal-UD-metal sandwich laminate (204, 205, 206) sandwiched by two UD layers (207/208, 209/210), by passing UD fibres provided with not yet consolidated matrix material through the laminating zone together with the metal-UD-metal sandwich laminate.

9. A method in accordance with any one of claims 2-8, characterized in that the double belt press comprises an isobaric laminating zone.

10. A method in accordance with claim 9, characterized in that at the edges of the material passed through the double belt press a viscous thermoplastic polymer is carried along parallel to the machine direction.

11. A method in accordance with any one of claims 1-10, characterized in that the metal foil is double treated copper foil.

12. A method in accordance with any one of claims 2-11, characterized in that the composite laminate is rendered suitable for the manufacture of multi-layer PWBs by having its outer sides coated, downstream of the laminating zone (21, 22), with an adhesive layer which still has to be brought to flow.

13. A method for manufacturing a printed wire board, characterised in that a composite laminate is manufactured in accordance with any one of the claims 1-12, wherein at least one outer surface of the composite laminate is rendered suitable for the application of traces of electrically conductive material.

14. A method in accordance with claim 13, characterized in that a foil of a metal suitable for the subtractive forming of conductive traces is laminated on the outer sides of the fibre-containing matrix material passed through the laminating zone.

15. A method in accordance with claim 13, characterized in that after passing through the laminating zone the composite laminate is coated on the outer sides with a base layer to promote the adhesion of electrolessly deposited copper traces.

16. A multi-layer PWB comprising at least three layers of patterned conductive material and at least two spacer layers comprising insulating material, characterized in that at least one spacer layer also comprises a conductive metal foil layer, said spacer layer being manufactured using a method in accordance with any one of claims 1-3.

17. The use of a composite laminate made by a method in accordance with any one of claims 2-11 for manufacturing a printed wire board.

18. The use of a composite laminate made by a method in accordance with any one of claims 2-11 for manufacturing an adhesive-coated spacer panel for a multi-layer PWB.

19. A substrate for a printed circuit (a PWB) comprising a composite laminate of which at least one outer surface has been rendered suitable for the deposition of traces of conductive material, the composite laminate comprising matrix material reinforced with unidirectionally oriented filaments such that the UD reinforcing filaments are present in different layers of crossing orientational directions, said layers being symmetrically positioned vis-à-vis a plane of symmetry through the centre of the laminate which runs parallel to its outer surfaces, characterized in that in addition to the layers of UD filaments the laminate contains two inner metal layers the metal layers being situated in mirror image symmetry in respect of the plane of symmetry.

## Patentansprüche

1. Verfahren zur Herstellung eines Verbundlaminates mit einer Mehrzahl von UD-Lagen, d.h. Lagen aus mit unidirektional orientierten Fasern verstärktem Matrixmaterial, und mindestens einer inneren Metalllage, d.h. einer Metalllage, die keine Aussenfläche des Laminats bildet, wobei die Lagen so angeordnet sind, dass sie ein ausgeglichenes und symmetrisches Laminat ergeben, bei welchem Verfahren unidirektional orientierte (UD) Fasern (5), die mit noch nicht verfestigtem Matrixmaterial (7) versehen sind, durch eine Laminierzone geführt und das Matrixmaterial verfestigt wird, dadurch gekennzeichnet, dass in einem ersten Schritt aus mindestens drei Lagen ein nicht flies-sendes Sandwichlaminat gebildet wird, wobei die mindestens drei Lagen UD (201, 203, 205) und Metalllagen (202, 204, 206)sind und alle Fasern in dem nicht fliessenden Sandwichlaminat eine einzige Orientierungsrichtung haben, wobei das Sandwichlaminat gebildet wird durch Führen von UD-Fasern, die mit noch nicht verfestigtem Matrixmaterial versehen sind, zusammen mit Metallfolie (9) durch die Laminierzone (13), und wobei in einem zweiten Schritt das nicht fliessende Sandwichlaminat auf seinen Aussenflächen mit UD-Lagen (207/208, 209/210) versehen wird, wobei gewünschtenfalls in nachfolgenden Schritten zusätzliche UD-Lagen zugefügt werden.

2. Verfahren nach Anspruch 1, dadurch gekennzeichnet, dass das Laminierverfahren unter Verwendung einer Doppelbandpresse durchgeführt wird.

3. Verfahren nach Anspruch 2, dadurch gekennzeichnet, dass in der Laminierzone längs der beiden Aussenflächen des nicht fliessenden Sandwichlaminates noch nicht verfestigtes Matrixmaterial eingeführt wird, das mit UD-Fasern versehen ist, die eine Orientierungsrichtung aufweisen, die etwa senkrecht zur Orientierungsrichtung im Sandwichlaminat verläuft.

4. Verfahren nach einem der Ansprüche 1 bis 3, dadurch gekennzeichnet, dass ein UD-Metall-UD-Sandwichlaminat durch Führen einer Metallfolie zwischen zwei Lagen aus UD-Fasern, die mit noch nicht verfestigtem Matrixmaterial versehen sind, und Führen der so auf beiden Flächen UD-verstärkten, unverfestigtes Matrixaterial enthaltenden Metallfolie durch die Laminierzone gebildet wird.

5. Verfahren nach Anspruch 4, dadurch gekennzeichnet, dass in der Laminierzone längs der beiden Aussenflächen des nicht fliessenden UD-Metall-UD-Sandwichlaminates (201, 202, 203) nicht verfestigtes Matrixmaterial eingeführt wird, das mit UD-Fasern versehen ist, die eine Orientierungsrichtung aufweisen, die annähernd senkrecht zur Orientierungsrichtung des UD-Metall-UD-Sandwichlaminates verläuft.

6. Verfahren nach Anspruch 5, dadurch gekennzeichnet, dass der gemessene Teil des UD-Metall-UD-Sandwichlaminates durch Zerschneiden eines endlosen UD-Metall-UD-Sandwichlaminates gebildet wird, das im ersten Schritt in einer Länge gebildet wird, die annähernd gleich der Breite ist.

7. Verfahren nach einem der Ansprüche 1 bis 3, dadurch gekennzeichnet, dass im ersten Schritt ein Metall-UD-Metall-Sandwichlaminat gebildet wird, wobei das Metall-UD-Metall-Sandwichlaminat eine UD-Lage (205) enthält, die sandwichartig zwischen zwei leitfähigen Metalllagen (204, 206) liegt, indem zwei Blatt oder Bänder aus Metallfolie durch die Laminierzone geführt werden, wobei die mit noch nicht verfestigtem Matrixmaterial versehenen UD-Fasern geführt werden, die zwischen diesen sind.

8. Verfahren nach Anspruch 7, dadurch gekennzeichnet, dass man im zweiten Schritt ein UD-Metall-UD-Metall-UD-Laminat bildet, das UD-Metall-UD-Metall-UD-Laminat, welches das Metall-UD-Metall-Sandwichlaminat (204, 205, 206) enthält, sandwichartig zwischen zwei UD-Lagen (207/208, 209/210) anordnet, indem man UD-Fasern, die mit noch nicht verfestigtem Matrixmaterial versehen sind, zusammen mit dem Metall-UD-Metall-Sandwichlamiant durch die Laminierzone führt.

9. Verfahren nach einem der Ansprüche 2-8, dadurch gekennzeichnet, dass die Doppelbandpresse eine isobare Laminierzone besitzt.

10. Verfahren nach Anspruch 9, dadurch gekennzeichnet, dass an den Kanten des durch die Doppelbandpresse geführten Materials ein viskoses thermoplastisches Polymer parallel zur Maschinenrichtung mitgeführt wird.

11. Verfahren nach einem der Ansprüche 1-10, dadurch gekennzeichnet, dass die Metallfolie eine doppel- behandelte Kupferfolie ist.

12. Verfahren nach einem der Ansprüche 2-11, dadurch gekennzeichnet, dass das Verbundlaminat zur Herstellung von Multilayer-PWBs geeignet gemacht wird, indem seine Aus-senseiten stromabwärts von der Laminierzone (21, 22) mit einer Klebstoffschicht versehen werden, die noch zum Fliessen gebracht werden müssen.

13. Verfahren zur Herstellung einer Leiterplatte, dadurch gekennzeichnet, dass ein Verbundlaminat gemäss einem der Ansprüche 1-12 hergestellt wird, bei dem mindestens eine Aussenfläche des Verbundlaminates zum Aufbringen von Pfaden aus elektrisch leitfähigem Material geeignet gemacht worden ist.

14. Verfahren nach Anspruch 13, dadurch gekennzeichnet, dass eine Folie aus einem für die subtraktive Bildung von leitfähigen Pfaden geeigneten Metall auf die Aussenseite des faserhaltigen Matrixmaterials, das durch die Laminierzone geführt wird, laminiert wird.

15. Verfahren nach Anspruch 13, dadurch gekennzeichnet, dass das Verbundlaminat nach dem Hindurchführen durch die Laminierzone auf den Aussenseiten mit einer Basislage versehen wird, um die Haftung von stromlos abgeschiedenen Kupferpfaden zu fördern.

16. Multilayer-PWB enthaltend mindestens drei Schichten aus gemustertem leitfähigen Material und mindestens zwei Isoliermaterial enthaltende Abstandslagen, dadurch gekennzeichnet, dass mindestens eine Abstandslage auch eine leitfähige Metallfolienlage besitzt, wobei die Abstandslage unter Anwendung des Verfahrens gemäss einem der Ansprüche 1-3 hergestellt ist.

17. Verwendung eines Verbundlaminates, das nach einem Verfahren gemäss einem der Ansprüche 2-11 hergestellt ist, zur Herstellung einer Leiterplatte.

18. Verwendung eines Verbundlaminates, das nach einem Verfahren gemäss einem der Ansprüche 2-11 hergestellt ist, zur Herstellung einer mit Klebstoff beschichteten Abstands-platte für einen Multilayer-PWB.

19. Substrat für eine gedruckte Schaltung (ein PWB), enthaltend ein Verbundlaminat, von dem mindestens eine Aussenfläche zur Ablagerung von Pfaden aus leitfähigem Material geeignet gemacht worden ist, wobei das Verbundlaminat Matrixmaterial enthält, das mit unidirektional orientierten Fasern so verstärkt ist, und die UD-verstärkenden Filamente in verschiedenen Lagen mit einander überkreuzenden Orientierungsrichtungen vorliegen, wobei die Lagen in bezug auf eine Symmetrieebene durch die Mitte des Laminats symmetrisch angeordnet sind, welche sich parallel zu ihren Aussenflächen erstreckt, dadurch gekennzeichnet, dass das Laminat zusätzlich zu den Lagen aus UD-Filamenten zwei innere Metalllagen besitzt, wobei die Metalllagen relativ zur Symmetrieebene spiegelbildlich symmetrisch angeordnet sind.

## Revendications

1. Un procédé de fabrication d'un stratifié composite présentant une pluralité de couches UD, c'est-à-dire de couches de matériau formant matrice renforcées par des fibres orientées unidirectionnellement et au moins une couche de métal intérieure, c'est-à-dire une couche de métal qui ne forme pas la couche extérieure du stratifié, les couches étant disposées de façon à former un stratifié équilibré et symétrique, le procédé comprenant le passage à travers une zone de stratification de fibres (5) unidirectionnellement orientées (UD) pourvues de matériau formant matrice non encore consolidé (7) et consolidation du matériau formant matrice, caractérisé en ce que, dans une première étape, on forme un stratifié en sandwich non-fluide composé d'au moins trois couches, ces au moins trois couches étant toutes des couches UD (201, 203 et 205) et de couches métalliques (202, 204, 206), toutes les fibres à l'intérieur du stratifié en sandwich à l'état non-fluide présentant une direction d'orientation unique, le stratifié en sandwich étant formé en faisant passer des fibres UD pourvues de matériau formant matrice non encore consolidé à travers la zone de stratification (13) ensemble avec la feuille métallique (9) et, dans une seconde étape, on applique sur le stratifié en sandwich à l'état non-fluide sur ses surfaces extérieures des couches UD (207/208, 209/210), des couches UD supplémentaires étant éventuellement ajoutées dans des étapes ultérieures.

2. Un procédé selon la revendication 1, caractérisé en ce que le procédé de stratification est mis en oeuvre en utilisant une presse à double courroie.

3. Un procédé selon la revendication 2, caractérisé en ce que, dans la zone de stratification, en même temps que les deux surfaces extérieures du stratifié en sandwich à l'état non-fluide, on introduit un matériau de matrice non encore consolidé pourvu de fibres UD présentant une direction d'orientation qui est sensiblement perpendiculaire à la direction d'orientation dans le stratifié en sandwich.

4. Un procédé selon une quelconque des revendications 1 à 3, caractérisé en ce qu'on forme un stratifié en sandwich métal-UD-métal en intercalant une feuille métallique entre deux couches de fibres UD pourvues de matériau formant matrice non encore consolidé et en faisant passer la feuille métallique contenant le matériau matrice non encore consolidé ainsi renforcé sur ses deux faces à travers la zone de stratification.

5. Un procédé selon la revendication 4, caractérisé en ce que, dans la zone de stratification, en même temps que les deux surfaces extérieures du stratifié en sandwich métal-UD-métal (201, 202, 203) à l'état non-fluide, on introduit un matériau de matrice non encore consolidé pourvu de fibres UD présentant une direction d'orientation qui est à peu près perpendiculaire à la direction d'orientation dans le stratifié en sandwich UD-métal-UD.

6. Un procédé selon la revendication 6, caractérisé en ce que la portion mesurée de stratifié en sandwich UD-métal-UD est formée par découpage de stratifié en sandwich UD-métal-UD sans fin formé dans la première étape à une longueur qui est environ égale à la largeur.

7. Un procédé selon une quelconque des revendications 1 à 3, caractérisé en ce que, dans la première étape, on forme un stratifié en sandwich métal-UD-métal, le stratifié en sandwich métal-UD-métal comprenant une couche UD (205) prise en sandwich entre deux couches métalliques conductrices (204, 206) en faisant passer deux feuilles ou bandes de feuilles métalliques à travers la zone de stratification en même temps, entre elles la fibre UD pourvue de matériau formant matrice non encore consolidé.

8. Un procédé selon la revendication 7, caractérisé en ce que, dans la seconde étape, on forme un stratifié UD-métal-UD-métal-UD, le stratifié UD-métal-UD-métal-UD comprenant le stratifié en sandwich métal-UD-métal (204, 205, 206) pris en sandwich entre deux couches UD (207/208, 209/210), en faisant passer des fibres UD pourvues de matériau formant matrice non encore consolidé à travers la zone de stratification en même temps que le stratifié en sandwich métal-UD-métal.

9. Un procédé en accord avec l'une quelconque des revendications 2 à 8, caractérisé en ce que la presse à double courroie comprend une zone de stratification isobare.

10. Un procédé selon la revendication 9, caractérisé en ce que, au bord du matériau acheminé par la presse à double courroie, un polymère thermoplastique visqueux est entraîné parallèlement à la direction machine.

11. Un procédé selon une quelconque des revendications 1 à 10, caractérisé en ce que la feuille métallique est une feuille de cuivre doublement traitée.

12. Un procédé selon une quelconque des revendications 2 à 11, caractérisé en ce que le stratifié composite est rendu convenable à la fabrication de PWB multicouche en revêtant ses faces extérieures, en aval de la zone de stratification (21, 22) d'une couche d'adhésif qui doit encore être mise sous forme fluide.

13. Un procédé de fabrication d'une carte de circuit imprimé (PWB), caractérisé en ce qu'on fabrique un stratifié composite selon une quelconque des revendications 1 à 12, dans lequel au moins une surface extérieure du stratifié composite est rendue convenable à l'application de traces de matériau électriquement conducteur.

14. Un procédé selon la revendication 13, caractérisé en ce qu'une feuille d'un métal convenant à la formation soustractive de traces conductrices est stratifié sur les faces extérieures du matériau formant matrice contenant des fibres passant à travers la zone de stratification.

15. Un procédé selon la revendication 13, caractérisé en ce que, après passage à travers la zone de stratification, le stratifié composite est revêtu sur ses faces extérieures d'une couche de base pour favoriser l'adhérence de traces de cuivre déposées par voie non électrolytique.

16. Un PWB multicouche comprenant au moins trois couches de matériau conducteur appliquées suivant un motif défini et au moins deux couches intercalaires comprenant du matériau isolant, caractérisé en ce que au moins une couche intercalaire comprend également une couche de feuille métallique conductrice, ladite couche intercalaire étant fabriquée en utilisant un procédé selon une quelconque des revendications 1 à 3.

17. Utilisation d'un stratifié composite fabriqué par un procédé selon une quelconque des revendications 2 à 11, pour la fabrication d'une carte de circuit imprimé.

18. Utilisation d'un stratifié composite fabriqué par un procédé selon une quelconque des revendications 2 à 11, pour la fabrication d'un panneau intercalaire revêtu d'adhésif destiné à un PWB multicouches.

19. Un substrat pour un circuit imprimé (un PWB) comprenant un stratifié composite dont au moins l'une des surfaces extérieures a été rendue convenable au dépôt de traces de matériau conducteur, le stratifié composite comprenant un matériau formant matrice renforcé par des filaments d'orientation unidirectionnelle, de telle sorte que les matériaux de renforcement UD soient présents dans différentes couches de direction d'orientation croisées, lesdites couches étant disposées symétriquement par rapport à un plan de symétrie passant par le centre du stratifié et s'étendant parallèlement à ses surfaces extérieures, caractérisé en ce que, outre les couches de filaments UD, le stratifié contient deux couches de métal intérieures, les couches métalliques occupant une position de symétrie analogue à celle d'objets et d'images par rapport à un miroir.
